Europäisches Patentamt

European Patent Office

Office européen des brevets

(11) Publication number: **0 156 528**
**B1**

## EUROPEAN PATENT SPECIFICATION

(45) Date of publication of patent specification: 30.01.91

(51) Int. Cl.5: **H 01 L 29/78, H 01 L 21/84**

(21) Application number: 85301362.1

(22) Date of filing: 28.02.85

(54) High-voltage thin-film transistor.

(30) Priority: 12.03.84 US 588485

(43) Date of publication of application:
02.10.85 Bulletin 85/40

(45) Publication of the grant of the patent:
30.01.91 Bulletin 91/05

(84) Designated Contracting States:
DE FR GB IT NL

(56) References cited:

ELECTRONICS & COMMUNICATIONS IN
JAPAN, vol. 64, no. 12, December 1981, pages
96-104, Scripta Publishing Co., Silver Spring,
Maryland, US; I. YOSHIDA et al.: "A composite
gate structure for enhanced-performance power
MOS FET's"

(73) Proprietor: XEROX CORPORATION
Xerox Square - 020
Rochester New York 14644 (US)

(72) Inventor: Tuan, Hsing Chien
1829 Channing Avenue
Palo Alto California 94303 (US)

(74) Representative: Weatherald, Keith Baynes et al
Rank Xerox Patent Department Albion House, 55
New Oxford Street
London WC1A 1BS (GB)

(56) References cited:
PROCEEDINGS OF THE 14th CONFERENCE
(1982 INTERNATIONAL) ON SOLID STATE
DEVICES, Tokyo, 1982, JAPANESE JOURNAL
OF APPLIED PHYSICS, vol. 22, 1983,
supplements no. 22-1, pages 487-491, Tokyo,
JP; M. MATSUMURA: "Amorphous silicon
transistors and integrated circuits"

EP 0 156 528 B1

## Description

This invention relates to high voltage thin film transistors and, more particularly, to devices which rely upon the unique properties of amorphous silicon.

Amorphous silicon thin film trufsistor (a-Si:H TFT) technology has matured significantly in the past several years. An example of amorphous silicon thin film transistor technology can be found in Japans Journal of Applied Physics, Supplements, Vol. 22 (1983) Supplement, no. 22—1, pp, 487—491, Tokyo, Japan. This is largely due to its simple, inexpensive and low temperature fabrication processes, which allow it to be deposited uniformly over large-area non-crystalline substrates, such as glass and ceramics. Thus, a-Si:H TFTs are particularly suitable for large-area electronics applications. In view of these attributes, it would be highly desirable to be able to provide large-area arrays of high voltage (i.e. above 500 volts) amorphous silicon transistor switches for driving electrographic stylii, wherein each individual writing stylus is controlled by its own switch. Such an arrangement would eliminate the more complex and expensive multiplexing schemes presently employed.

Today, the only commonly available high voltage integrated circuit devices utilize crystalline silicon technology. An example can be found in Electronics & Communications in Japan, vol. 64, no. 12, (1981), pp. 96—104, Script Publishing Co., Silver Spring, Md, US. However, because of the processing limitations of this material, coupled with the need to incorporate structural safeguards to maximize the drain breakdown voltage, they are generally complex and therefore, expensive.

Various solutions have been achieved. For example, one approach has been to provide a thin gate oxide layer for allowing low voltage switching operation, and offsetting the drain electrode from the gate, while ion implanting the offset region to form a shallow diffused resistors for lowering the field seen by the gate. The doping step for the diffused resistor region is extremely critical. Another approach has been to deposit a thick protective oxide layer between the drain and the gate and to deposit a polysilicon load resistor over the oxide. These also require critical doping of the diffused resistor as well as requiring thick dielectric layers on the order of one micron. It should be apparent that the known solutions for providing high voltage transistors in crystalline silicon are complex and expensive.

Perhaps a more prejudicial factor regarding crystalline silicon high voltage transistors is the wafer size limitation of about three to four inches, which militates against full page-width switch arrays. Of course, wafer interconnection for providing eleven inch page-widths or a thirty-six inch plotter-widths, is possible, however it would necessitate further expenses.

In order for a high voltage transistor to operate satisfactorily, it is important that the transistor may be switched ON and OFF by a low voltage gate signal, so that the gate may rapidly be brought up to switching potential. Clearly, the higher the switching potential on the gate, the longer it takes to effect.

It is an object of the present invention to provide a simply processed, low cost high voltage thin film transistor which is capable of being fabricated in large-area arrays.

It is a further object of the present invention to provide a high voltage thin film transistor utilizing amorphous silicon technology.

These and other objects may be carried out, in one form, by providing an amorphous silicon high voltage thin transistor including a source electrode and a drain electrode spaced relative to one another in a lateral direction, the source electrode is also spaced relative to a gate electrode in a vertical direction normal to the lateral direction and the source electrode and gate electrode are superimposed upon one another. A charge carrier transport layer extends laterally between and is in intimate physical and electrical contact with the source electrode and the drain electrode, and is positioned between the gate electrode and the source electrode. The charge carrier transport layer is highly resistive and will only allow significant current to flow therethrough after charge carriers are injected therein. A dielectric layer is located between the gate electrode and the charge carrier transport layer. The gate electrode controls the injection of charge carriers from the source electrode into the charge carrier transport layer for causing current conduction therethrough.

A more complete understanding of the present invention and its attendant advantages may be obtained by reference to the following description taken in conjunction with the accompanying drawings in which:

Figure 1 is a schematic cross-sectional view of one form of the amorphous silicon high voltage transistor of this invention.

Figure 2 is a schematic cross-sectional view of another form of the amorphous silicon high voltage transistor of this invention.

Figure 3 is a schematic cross-sectional view of yet another form of the amorphous silicon high voltage transistor of this invention.

Figure 4 is a graphical representation of the output characteristics of a typical amorphous silicon high voltage transistor of this invention, and

Figure 5 is a graphical representation of the band bending phenomenon upon which this invention relies.

The principle of operation of the a-Si:H TFT device of this invention depends upon the unique flexibility and simplicity of processing steps available to the fabrication of amorphous silicon devices and upon the somewhat unique transport properties of the amorphous silicon. Since it can be deposited uniformly, at relatively low temperatures (on the order of less than 350°C), over large area non-crystalline substrates such as glass and ceramics a large-area array of transistor structures, of the form described below, can be readily made. The two characteristics of amorphous silicon which are relied upon to enable operation of the unique device described herein, are the extremely high resistivity of the amorphous silicon material, causing it to behave similar to a dielectric material, and its ability to allow charge carriers to drift therethrough and cause current conduction once charge carriers are injected into it.

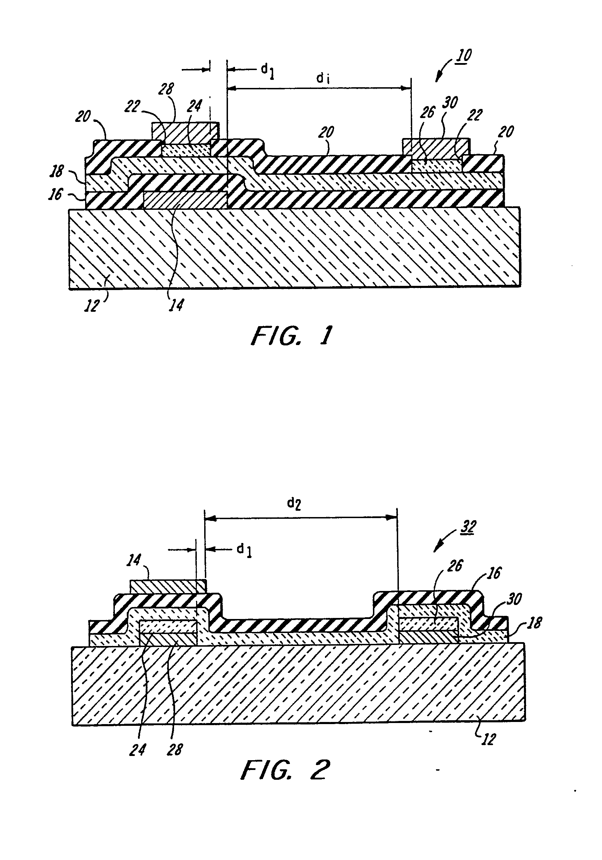

Turning now to the drawings there is illustrated in Figure 1 a device 10 comprising a substrate 12 made of any suitable material, such as glass or ceramic, upon which is deposited a thin metal layer 14 patterned to form the gate electrode of the device. The gate electrode 14 may be made of any suitable material, such as Cr, NiCr, or other material. Overlying the gate and substrate, is a layer of gate dielectric material 16, usually silicon nitride or silicon dioxide. An undoped, or very lightly dopped, amorphous silicon layer 18 lies upon the dielectric layer 16 and is covered by a passivation dielectric layer 20 usually, but not necessarily, of the same material as the gate dielectric 16. Windows 22 etched into the passivation layer 20 provide openings for the source electrode 24 and drain electrode 26. The source electrode is preferably amorphous silicon suitably doped to provide charge carriers of the desired type, i.e. electrons $(n^+)$ or holes $(p^+)$. Finally, metal source and drain contacts 28 and 30, respectively, of a suitable conductive material, such as Al, overlie the source and drain electrodes 24 and 26. The source contact is usually connected to ground, or to a suitable reference potential; the drain contact is usually connected, through a load resistor, to a high voltage supply (on the order of several hundred volts) of a suitable polarity with respect to the polarity of the charge carriers (positive for electron carriers or negative for hole carriers); and the gate is connected to a switchable low voltage supply (on the order of five to fifteen volts).

As illustrated in Figure 1, the source electrode 24 and the gate electrode 14 are both laterally offset from the drain electrode 26, and the gate electrode 14 underlies the source electrode. The gate electrode is somewhat larger than the source electrode and, in particular, extends a short distance beyond the source electrode toward the drain electrode, a distance $d_1$. A distance $d_2$ separates the right edge of the gate electrode from the left edge of the drain electrode. As will become apparent, when the theory of operation is discussed below, while it is desirable that the gate electrode extends closer to the drain electrode than does the source electrode, a gate/source overlap is not absolutely imperative for adequate functioning of the device. However, it is necessary that the edges of the source and gate electrodes facing the drain electrode are at least aligned, in order that the gate electrode may function to switch the transistor completely OFF.

If the proposed relationship between the several elements is observed, any number of variations in the configuration of the thin film high voltage transistor of this invention, are possible. For example, in Figure 2 there is illustrated an inverted device 32, wherein the source and drain are positioned directly upon the substrate. For clarity, the same numerals have been applied as in Figure 1.

The undoped, or lightly doped, amorphous silicon layer 18 has an extremely high, dark resistivity (typically greater than $10^9$ ohm-cm). Current conduction therein in the ohmic regime, by thermally generated carriers, is so insignificant that, for practical purposes, it essentially can be considered as an insulating layer, as far as the population of conduction carriers is concerned. Normally, a high barrier to the movement of carriers exists across the interface between the $n^+$ amorphous silicon source electrode and the amorphous silicon charge transport layer. However, absent additional controls, a sufficiently large positive potential on the remote drain electrode will usually be able to draw some electrons out of the source electrode and in the amorphous silicon transport layer. As will be explained below, the gate electrode serves to control the injection of charge carriers across the source electrode interface, thereby controlling both the ON and OFF current through the amorphous silicon layer.

Just as in a vacuum tube, a potential difference alone between two electrodes, does not result in current conduction through the vacuum, the very high resistivity of the amorphous silicon layer will normally prevent current conduction between the source and the drain electrodes. Continuing with the vacuum tube analogy, it is well known that electrons can travel through the vacuum, causing current conduction, under the influence of an electric field, once they are injected into the vacuum. In order to inject electrons into the vacuum, a heated cathode is provided adjacent one of the electrodes and a grid, or other control device, allows electrons to enter the region between the electrodes and be swept between them by the high potential field. Similarly, carriers can drift through amorphous silicon layer 18 and provide current conduction, once they are injected therein.

Since the source electrode is separated from the gate electrode by several thousand Angstroms and is separated from the drain electrode by several microns, the effect of a low potential on the gate will prevail over the high potential on the drain. Thus, control of charge injection of electron charge carriers, supplied by the $n^+$ doped amorphous silicon source electrode 24, is accomplished by the gate electrode 14.

In the OFF state, a potential of zero volts, or of a low negative voltage, is applied to the gate electrode to suppress electron carrier injection from the source electrode into the amorphous silicon. In the ON state, a positive voltage, on the order of five to fifteen volts, is applied to the gate electrode. This attracts electrons across the interface from the source electrode into the amorphous silicon charge carrier transport layer. Once the electrons are in the amorphous silicon layer they will be further attracted by the drain potential and cause current flow.

The degree of control exercised by the gate electrode, upon the injection and suppression of charge carriers, is greatly dependent upon the spatial relationship between the gate and source electrodes. If, as shown in Figure 1, the gate electrode completely spans the source electrode it will exert maximum control thereover. However, if the source electrode extends beyond the gate electrode, in the direction toward the drain electrode, those portions will not be substantially influenced by the gate electrode. Those extending portions will fall under the influence of the high voltage drain electrode which will effect injection of charge carriers into the tranport layer, independent of the gate electrode state. The extent of the effect will depend on the proximity of the extending portion of the source electrode to the drain electrode. Nevertheless, the gate electrode would not be effective to establish a completely OFF condition.

If the gate electrode extends beyond the source electrode in the direction of the drain electrode (as shown), an aditional benefit is achieved by the effect of the gate voltage on the amorphous silicon charge carrier transport layer. In the ON condition, the positive gate voltage forms an electron accumulation zone in the $d_1$ region of the amorphous silicon transport layer and effectively extends the source electrode to the right edge of the gate electrode. The electrons now only have to drift across the distance $d_2$ to reach the drain electrode, enabling the drain electrode to extract electrons at a lower drain voltage. Conversely, in the OFF condition, the zero, or negative, gate voltage further depletes the transport layer by driving electrons out of its $d_1$ region and increases the effective distance between the source and drain electrodes. A larger effective separation between the source and drain electrodes decreases the electric field, along the conduction path, in the amorphous silicon transport layer and further undermines the effectiveness of the high drain voltage to extract electrons from the source electrode.

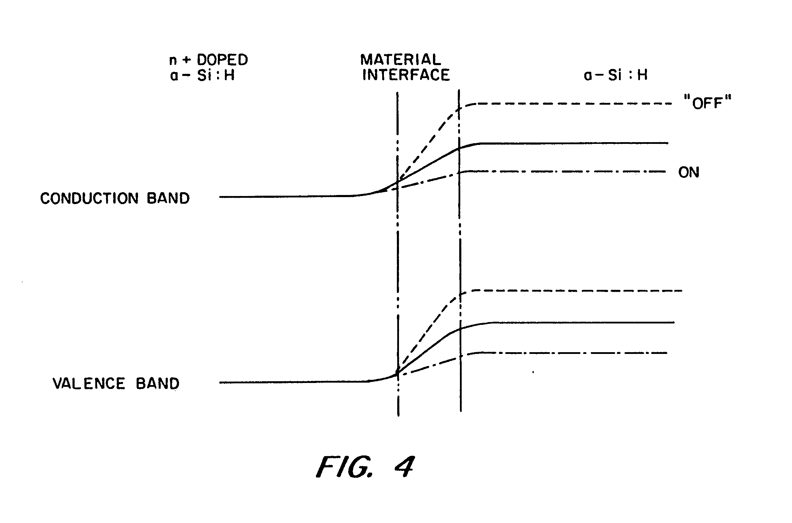

The above-described effects, of the gate electrode upon the charge injection properties from the $n^+$ source electrode into the amorphous silicon transport layer, rely upon the band bending phenomenon illustrated in Figure 4. As shown in that drawing, a pair of phantom vertical lines approximately centrally spaced, respresents the interface zone between the amorphous silicon transport layer 18 and the $n^+$ doped amorphous silicon source electrode. For each material, a conduction band and a valence band is shown, separated by an energy bandgap. It should be noted that at the interface there is a built-in potential barrier, as represented by the slope of the curves in the interface zone.

Band bending is illustrated by three pairs of conduction and valence bands at the interface and in the regions adjacent the interface between the $n^+$ doped amorphous silicon source electrode and the amorphous silicon transport layer. The central pair (solid lines) represents a thermal equilibrium condition when no potential is applied to the gate electrode. An upper pair (dotted lines) represents the result of band bending when the gate electrode has a low negative voltage applied (the OFF condition), indicating an increased barrier to injection of electrons from the source electrode. The lower pair (double dotted lines) represents the result of band bending when the gate electrode has a low positive voltage applied (the ON condition), indicating a decreased barrier to injection of electrons from the source electrode. In this state, electrons are readily injected into the amorphous silicon transport layer.

In Figure 5 the electrical characteristics of the high voltage thin film transistor of the present invention are illustrated. Drain current $1_{DS}$ is plotted against source-drain voltage $V_{DS}$, for various gate voltages $V_G$. For low values of $V_{DS}$ (in Region I) the low drain voltages are not large enough to remove injected electrons, across the amorphous silicon transport layer, at a fast enough rate. Thus, electrons injected from the source into the amorphous silicon transport layer will bunch-up, further inhibiting injection. This condition is apparent, since for each increment of increase in voltage there is a corresponding increase in current. However, in Region II, $V_{DS}$ is large enough to move essentially all the electrons injected from the source across the amorphous silicon transport layer. This condition is apparent, since for increases in $V_{DS}$, $I_{DS}$ stays essentially flat. In Region II, $I_{DS}$ is only limited by the ability of the source electrode to inject electrons, as governed by the gate voltage $V_g$.

In order to achieve maximum drain current for a given drain voltage and gate voltage, the transistor should be operated in Region II. If the dimension $d_2$ of the transistor is too long, the drain electrode will be so far from the source electrode that the electric field, seen by the electrons injected into the amorphous silicon transport layer, will be too small to transport all the injected electrons thereacross, i.e. the transistor will be operating in Region I. On the other hand, if the dimension $d_2$ is too short, the gate dielectric layer 16 will not sustain the high potential between the drain electrode and the gate electrode, and breakdown will occur between the drain and the gate. Thus, it should be apparent that a balance must be stuck in selecting this dimension. Additionally, in order to prevent air breakdown between the source and drain contacts, a high dielectric strength layer would be used to coat the device.

A representative example of some approximate dimensions which have been used in a successful device is as follows: the gate electrode layer was 80 nm thick, the gate dielectric layer, the amorphous silicon layer and the passivation dielectric layer were on the order of 100 to 300 nm thick, the n+ doped amorphous silicon source and drain electrodes were on the order of 50 to 100 nm thick, the metal source and drain contact layers were thick enough for complete step coverage, and the dimension $d_1$ was approximately 5 μm. The distance $d_2$ was 10 to 30 μm.

Under these conditions, a +600 volt potential applied to the drain electrode had a tendency to draw electrons out of the source electrode and into the amorphous silicon layer. But, since the drain electrode is aout one hundred times further away from the source electrode than is the gate electrode, the gate electrode with only zero or −5 volts applied thereto was sufficient to suppress electron charge injection and maintain the OFF state.

The flexibility of the fabrication processes available for amorphous silicon devices allows this unique structure to be made. As fully described above, this device relies upon the sandwiching of an undoped, or lightly doped, amorphous silicon layer 18 between a conductive gate electrode 14 and an n+ doped source electrode 24, in order that the gate electrode can control injection from the facing surface of the source electrode. A dielectric layer, separating the gate electrode from the amorphous silicon transport layer, prevents the gate electrode from drawing any current from the circuit and requires that the injected electrons be transported to the drain electrode. Such a construction is not possible in single crystal silicon where the starting material is the silicon wafer and all features are either diffused downward from the surface or built upward thereon. With amorphous silicon, the starting material may be any suitable substrate upon which metal layers, dielectric layers and amorphous silicon layers (doped, undoped or lightly doped) may be deposited, at relatively low temperatures, in any desired order.

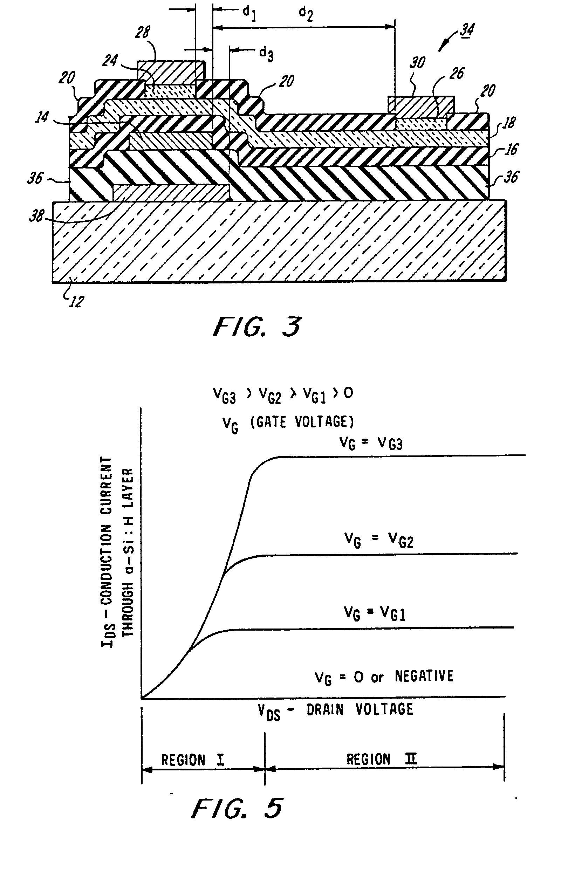

The embodiment of Figure 3 is suggested as an alternative construction which further increases the breakdown voltage. Since the high voltage thin film trunsistor 34 includes the same arrangement of elements as does transistor 10 (Figure 1), with but one modification, the same numerals will be used to identify the same parts. An additional gate electrode 38, separated from the gate electrode 14 by a thick dielectric gate electrode layer 36 (about 1 to 2 microns), extends closer to the drain electrode, than does the gate electrode 14, by the dimension $d_3$. The additional gate electrode 36 is maintained at the source electrode potential (usually ground) and thereby causes the potential of the amorphous silicon charge transport layer 18 in the $d_3$ region to be low, thus reducing the possibility of breaking down the thinner first dielectric layer 16.

A novel high voltage amorphous silicon thin film transistor has been described. In it, a gate electrode is employed to control the carrier injection efficiency of the source electrode. The main current conduction mechanism of the present high voltage transistor device is by the drift of carriers through a highly resistive amorphous silicon layer. Also, by judicious selection of the dimensions and the relative positioning of the various elements the virtual distances between the elements may be modified to the advantage of the device.

**Claims**

1. A high voltage thin film transistor (10) characterised by including

a substrate (12) upon which are supported a source electrode (24) and drain electrode (26) spaced relative to one another in a lateral direction, the source electrode being also spaced relative to gate electrode (14) in a vertical direction normal to the lateral direction, and wherein the source electrode and the gate electrode are superimposed upon one another,

charge carrier transport means (18) extending laterally between and in intimate physical and electrical contact with the source electrode and the drain electrode, the charge carrier transport means being positioned between the gate electrode and the source electrode wherein the charge carrier transport means will allow current to flow therethough only after charge carriers are injected therein, and

dielectric means (16) located between the gate electrode and the charge carrier transport means,

whereby the gate electrode controls the injection of charge carriers from the source electrode into the charge carrier transport means for causing current conduction through the transport means.

2. The high voltage transistor as recited in claim 1 characterised in that said source electrode means and said charge carrier transport msans are in charge injecting contact and said drain electrode means and said charge carrier transport means are in charge collecting contact.

3. The high voltage transistor as recited in claim 2 characterised in that said charge carrier transport means comprises an amorphous silicon layer.

4. The high voltage transistor as recited in claim 3 characterized in that said source electrode means and said drain electrode means comprise n+ amorphous silicon.

5. The high voltage transistor as recited in claim 4 characterized in that said gate electrode means is electrically conductive.

6. The high voltage transistor as recited in claim 3 characterized in that the closest distance between said drain electrode means and said source electrode means is about a hundred times greater than the closest distance between said gate electrode means and said source electrode means.

7. The high voltage transistor as recited in claim 6 characterized in that a switching potential is applied to said gate electrode means and a drain potential is applied to said drain electrode means, said drain potential being about a hundred times greater than said switching potential.

8. The high voltage transistor as recited in claim 2 characterized in that said gate electrode means extends closer to said drain electrode means in said lateral direction than does said source electrode means.

9. The high voltage transistor as recited in claim 8 characterized in that said gate electrode means and said source electrode means are in alignment and said gate electrode means has an area larger than said source electrode means.

10. The high voltage transistor as recited in claim 2 characterized in that said gate electrode means and said source electrode means are in alignment and said gate electrode means has an area at least as large as said source electrode means.

11. The high voltage transistor as recited in claim 2 characterized by further including second gate electrode means spaced from said gate electrode means in the direction normal to said lateral direction and superimposed upon said gate electrode means, and second dielectric means located between said gate electrode means and said second gate electrode means, said second gate electrode means being electrically connected to said source electrode means and extending closer to said drain electrode means in said lateral direction than does said gate electrode means.

12. The high voltage transistor as recited in claim 11 characterized in that the thickness of said second dielectric means is about an order of magnitude less than the distance between said drain electrode means and the closest portion of said gate electrode means.

**Patentansprüche**

1. Hochspannungs-Dünnfilmtransistor (10) dadurch gekennzeichnet, daß er enthält:

Ein Substrat (12), auf dem eine Source-Elektrode (24) und eine Drain-Elektrode (26) gehalten sind, die relativ zueinander in Querrichtung Abstand haben, wobei die Source-Elektrode auch Abstand zu einer Gate-Elektrode (14) in einer vertikalen Richtung senkrecht zur Querrichtung hat und wobei die Source-Elektrode und die Gate-Elektrode übereinander angeordnet sind,

Ladungsträgertransporteinrichtungen (18), die sich quer zwischen und in enger physikalischer und elektrischer Berührung mit der Source-Elektrode und der Drain-Elektrode erstrecken, wobei die Ladungsträgertransporteinrichtungen zwischen der Gate-Elektrode und der Source-Elektrode liegen, wobei die Ladungsträgertransporteinrichtungen einen Stromfluß hindurch nur nach Injektion der Ladungsträger darin ermöglichen, und

eine dielektrische Einrichtung (16), die zwischen der Gate-Elektrode und der Ladungsträgertransporteinrichtung liegt, wodurch die Gate-Elektrode die Injektion von Ladungsträgern aus der Source-Elektrode in die Ladungsträgertransporteinrichtung steuert, um eine Stromleitung durch die Transporteinrichtung zu verursachen.

2. Hocspannungstransistor nach Anspruch 1, dadurch gekennzeichnet, daß die Source-Elektrodeneinrichtung und die Ladungsträgertransporteinrichtung in Ladungsinjektionsberührung sind und die Drain-Elektrodeneinrichtung und die Ladungsträgertransporteinrichtung in Ladungsauffangberührung sind.

3. Hochspannungstransistor nach Anspruch 2, dadurch gekennzeichnet, daß die Ladungsträgertransporteinrichtung eine amorphe Siliciumschicht enthält.

4. Hochspannungstransistor nach Anspruch 3, dadurch gekennzeichnet, daß die Source-Elektrodeneinrichtung und Drain-Elektrodeneinrichtung amorphes $n^+$-Silicium enthalten.

5. Hochspannungstransistor nach Anspruch 4, dadurch gekennzeichnet, daß die Gate-Elektrodeneinrichtung elektrisch leitfähig ist.

6. Hochspannungstransistor nach Anspruch 3, dadurch gekennzeichnet, daß der engste Abstand zwischen der Drain-Elektrodeneinrichtung und der Source-Elektrodeneinrichtung etwa einhundertmal größer ist als der engste Abstand zwischen der Gate-Elektrodeneinrichtung und der Source-Elektrodeneinrichtung.

7. Hochspannungstransistor nach Anspruch 6, dadurch gekennzeichnet, daß ein Schaltpotential der Gate-Elektrodeneinrichtung zugeführt wird und ein Drain-Potential der Drain-Elektrodeneinrichtung zugeführt wird, wobei das Drain-Potential etwa einhundertmal größer als das Schaltpotential ist.

8. Hochspannungstransistor nach Anspruch 2, dadurch gekennzeichnet, daß die Gate-Elektrodeneinrichtung sich enger an der Drain-Elektrodeneinrichtung in der genannten Querrichtung erstreckt als die Source-Elektrodeneinrichtung.

9. Hochspannungstransistor nach Anspruch 8, dadurch gekennzeichnet, daß die Gate-Elektrodeneinrichtung und die Source-Elektrodeneinrichtung aufeinander ausgerichtet sind und die Gate-Elektrodeneinrichtung eine Fläche hat, die größer als die Source-Elektrodeneinrichtung ist.

10. Hochspannungstransistor nach Anspruch 2, dadurch gekennzeichnet, daß die Gate-Elektrodeneinrichtung und die Source-Elektrodeneinrichtung ausgerichtet sind und die Gate-Elektrodeneinrichtung eine Fläche hat, die wenigstens so groß ist, wie die Source-Elektrodeneinrichtung.

11. Hochspannungstransistor nach Anspruch 2, dadurch gekennzeichnet, daß er weiterhin eine zweite Gate-Elektrodeneinrichtung hat, die von der genannten Gate-Elektrodeneinrichtung in der Richtung senkrecht zur genannten Querrichtung Abstand hat und über der Gate-Elektrodeneinrichtung liegt, und daß eine zweite dielektrische Einrichtung zwischen der Gate-Elektrodeneinrichtung und der zweiten Gate-Elektrodeneinrichtung liegt, wobei die zweite Gate-Elektrodeneinrichtung elektrisch mit der Source-Elektrodeneinrichtung verbunden ist und sich enger zur Drain-Elektrodeneinrichtung in der genannten Querrichtung erstreckt als die genannte Gate-Elektrodeneinrichtung.

12. Hochspannungstransistor nach Anspruch 11, dadurch gekennzeichnet, daß die Dicke der zweiten dielektrischen Einrichtung etwa in einer Größenordnung liegt, die geringer als die Distanz zwischen der Drain-Elektrodeneinrichtung und dem nächstliegenden Abschnitt der Gate-Elektrodeneinrichtung ist.

**Revendications**

1. Transistor à couche mince de haute tension (10), caractérisé en ce qu'il comprend:

— un substrat (12) sur lequel sont supportées une électrode de source (24) et une électrode de drain (26) espacées l'une par rapport à l'autre dans la direction latérale, l'électrode de la source étant également espacée par rapport à l'électrode de la grille (14) dans une direction verticale perpendiculaire à la direction latérale, et où l'électrode de la source et l'électrode de la grille sont superposées;

— un moyen (18) de transport de porteurs de charges s'étendant latéralement entre l'électrode de la source et l'électrode de drain en étant en contact physique et électrique intime avec elles, le moyen de transport des porteurs de charges étant placé entre l'électrode de la grille et l'électrode de la source où le moyen de transport des porteurs de charges permettra au courant de ne circuler qu'après l'injection des porteurs de charge, et

— un moyen diélectrique (16) placé entre l'électrode de la grille et le moyen de transport des porteurs de charges,

d'où il résulte que l'électrode de la grille commande l'injection des porteurs de charge entre l'électrode de la source et le moyen de transport des porteurs de charge pour provoquer la conduction du courant à travers le moyen de transport.

2. Transistor à haute tension selon la revendication 1, caractérisé en ce que le moyen d'électrode de source et le moyen de transport des porteurs de charge sont en contact d'injection de charges, et le moyen d'électrode de drain et le moyen de transport des porteurs de charges sont en contact de collecte de charges.

3. Transistor à haute tension selon la revendication 2, caractérisé en ce que le moyen de transport des porteurs de charges comprend une couche de silicium amorphe.

4. Transistor à haute tension selon la revendication 3, caractérisé en ce que le moyen d'électrode de source et le moyen d'électrode de drain sont en silicium amorphe $n^+$.

5. Transistor à haute tension selon la revendication 4, caractérisé en ce que le moyen d'électrode de grille est conducteur de l'électricité.

6. Transistor à haute tension selon la revendication 3, caractérisé en ce que la distance plus étroite entre le moyen d'électrode de drain et le moyen d'électrode de source est environ cent fois plus grande que la distance la plus étroite entre le moyen d'électrode de grille et le moyen d'électrode de source.

7. Transistor à haute tension selon la revendication 6, caractérisé en ce qu'un potentiel de commutation est appliqué au moyen d'électrode de grille et un potentisl de drain est appliqué au moyen d'électrode de drain, le potentiel du drain étant environ cent fois plus grand que le potentiel de commutation.

8. Transistor à haute tension selon la revendication 2, caractérisé en ce que le moyen d'électrode de grille s'étend plus près du moyen d'électrode de drain dans la direction latérale que le moyen d'électrode de source.

9. Transistor à haute tension selon la revendication 8, caractérisé en ce que le moyen d'électrode de grille et le moyen d'électrode de source sont en alignement et le moyen d'électrode de grille a une surface supérieure à celle du moyen d'électrode de source.

10. Transistor à haute tension selon la revendication 2, caractérisé en ce que le moyen d'électrode de grille et le moyen d'électrode de source sont en alignement et le moyen d'électrode de grille a une surface au moins aussi grande que celle du moyen d'électrode de source.

11. Transistor à haute tension selon la revendication 2, caractérisé en ce qu'il comprend en outre un second moyen d'électrode de grille distant dudit moyen d'électrode de grille dans la direction perpendiculaire à la direction latérale et superposé à cedit moyen d'électrode de grille, et un second moyen diélectrique placé entre ledit moyen d'électrode de grille et le second moyen d'électrode de grille, le second moyen d'électrode de grille étant connecté électriquement au moyen d'électrode de source et s'étendant plus près du moyen d'électrode de drain dans la direction latérale que ledit moyen d'électrode de grille.

12. Transistor à haute tension selon la revendication 11, caractérisé en ce que l'épaisseur du second moyen diélectrique est inférieure d'environ un ordre de grandeur à la distance entre le moyen d'électrode de drain et la partie la plus proche dudit moyen d'électrode de grille.

FIG. 1

FIG. 2

FIG. 3

FIG. 5

FIG. 4